(19) Europäisches Patentamt
European Patent Office
Office européen des brevets

(11) **EP 1 398 872 B1**

(12) **EUROPEAN PATENT SPECIFICATION**

(45) Date of publication and mention
of the grant of the patent:
**06.02.2008 Bulletin 2008/06**

(51) Int Cl.:
**H03D 3/00** (2006.01)

(21) Application number: **02020537.3**

(22) Date of filing: **16.09.2002**

(54) **Adaptive autocalibration method for the quadrature demodulator of a five-port receiver**

Adaptives Selbstkalibrierungsverfahren für einen Quadraturdemodulator eines Fünfport-Empfängers

Procédé pour calibrer automatiquement un démodulateur en quadrature dans un récepteur à cinq portes

(84) Designated Contracting States:
**DE FR GB**

(43) Date of publication of application:
**17.03.2004 Bulletin 2004/12**

(73) Proprietor: **Sony Deutschland GmbH**
**10785 Berlin (DE)**

(72) Inventors:
• **Wang, Zhaocheng,**
**Sony International (Europe) GmbH**
**Heinrich-Hertz-Strasse 1**
**70327 Stuttgart (DE)**
• **Ratni, Mohamed,**
**Sony International (Europe) GmbH**
**Heinrich-Hertz-Strasse 1**
**70327 Stuttgart (DE)**

• **Krupezevic, Dragan,**
**Sony Internat. (Europe) GmbH**
**Heinrich-Hertz-Strasse 1**
**70327 Stuttgart (DE)**
• **Jürgensen, Jens-Uwe,**
**Sony Internat. (Europe) GmbH**
**Heinrich-Hertz-Strasse 1**
**70327 Stuttgart (DE)**

(74) Representative: **Rupp, Christian et al**
**Mitscherlich & Partner**
**Patent- und Rechtsanwälte**
**Sonnenstrasse 33**
**80331 München (DE)**

(56) References cited:
**EP-A- 0 884 836** **EP-A- 1 067 675**
**WO-A-02/05444**

EP 1 398 872 B1

**Description**

FIELD AND BACKGROUND OF THE INVENTION

The underlying invention relates to the field of mobile RF receivers with N-port circuit topologies, especially to a quadrature demodulator attached to a five-port junction device of a mobile RF receiver with three power sensors, which can advantageously be used for the processing and direct down-conversion of broadband (modulated) RF signals within an operation bandwidth f.e. between 1 and 7 GHz, and particularly to different parameter estimation and autocalibration techniques for a five-port junction device of a mobile RF receiver that can be applied to implement a multiple-mode and/or standard platform.

Five-port technology is known to accurately measure both amplitude and phase of the scattering parameters in a microwave network. Instead of using heterodyne receivers, a five-port receiver accomplishes direct measurements at millimeter and microwave frequencies to perform a direct demodulation of received RF signals by reading power levels at three of the five ports. The imperfections of the applied hardware such as phase errors of the bridges, imbalances of the power detectors, etc. can readily be eliminated by means of an appropriate calibration procedure. This significantly reduces the requirements of a hardware implementation and enables the five-port receiver to be operated within a wide band up to millimeter wave frequencies. Thereby, very accurate measurements can be made over a large dynamic range and a wide frequency range.

Due to their low power consumption and broadband frequency characteristics, five-port junction devices can be used for multimode and multiband wireless communication systems and provide a promising RF solution for software-defined radio transmission. One of their main problems is the accurate evaluation of calibration coefficients, which are used to calculate the inphase (I) and quadrature (Q) components of the complex-valued baseband signal from three input power levels. The circuitry which is deployed to realize this function is called digital front-end (DFE). For different carrier frequencies, different temperatures and even different boards using the same design, these parameters are different and need to be evaluated, which makes mass production a difficult task. Furthermore, conventional calibration methods do not guarantee the accuracy of these parameters, which introduce I/Q imbalances and DC offsets. A possible solution to overcome these problems is to deploy an additional module directly after the DFE, which provides an I/Q imbalance correction and DC offset cancellation. Owing to additional real-time processing introduced by this module, the employed hardware becomes more complex, and therefore power consumption is substantially increased.

In case adequate calibration procedures are applied, the influences of non-ideal passive RF components - including manufacturing tolerances - can be minimized. For example, a five-port receiver detects the relative phase and relative magnitude of two incoming RF signals. Its circuitry can be realized by passive components in combination with detector diodes for the detection of the relative phase and the relative amplitude of the RF signals. In this connection, an important feature of five-port receivers consists in the possibility of overcoming fabrication tolerances by means of a calibration procedure, which allows low-cost production.

BRIEF DESCRIPTION OF THE PRESENT STATE OF THE ART

According to the state of the art, there are different approaches and methods which are specially designed to cope with the problem of RF down-conversion using N-port technology. An N-port junction device in a conventional mobile RF receiver according to the state of the art that can be employed for the processing and direct down-conversion of modulated RF signals from the passband to the baseband can ideally be considered

-     as a structure with a perfect matching,
-     as a structure that contains different sub-parts with a resistive or reactive power splitting functionality, and
-     as a structure that may comprise at least one resistive power divider with an isolation function.

For all of these cases, it shall be assumed that the power detector structures are ideally matched. Their number may vary from one to ($N$-2). In reality however, due to the manufacturing process, the passive and active parts react in such a way that the ideal functionality of the sub-parts is not fulfilled, which means that a calibration procedure is necessary to cope with this problem.

The PCT patent application PCT/EP98/08329 refers to an N-port junction device (with $N \geq 4$ ports) which is used in the receiver of a mobile telecommunications device for processing modulated RF signals.

From the European patent application EP 0 957 573 A1, a five-port junction device is known which can be used for processing received RF signals in order to perform a direct down-conversion of said RF signals.

In the article "A Six-Port Direct Digital Millimeter Wave Receiver" (Digest of the IEEE MTT Symposium, vol. 3, pp. 1659-1662, San Diego, May 1994) by J. Li, R. G. Bossisio and K. Wu, the European patent application EP 0 957 573 A1 and the US patent 5,498,969, a calibration procedure for a reduction or compensation of non-linear effects caused by imperfections of the herein employed circuit elements is proposed.

Another approach for a linear calibration of an $N$-port receiver (with $N = 5$ or $N = 6$ ports) is disclosed in the European patent application EP 1 067 675 A1. Said $N$-port receiver comprises a first input port for the RF band-pass signal $S_1$ to be detected, a second input port for a carrier signal $S_2$ originating from a local oscillator (LO) and ($N$-2) output terminals. Thereby, calibrating signals based on the carrier signal $S_2$ are generated and fed to the first input port and/or the second input port of said $N$-port receiver. The calibration coefficients are calculated on the basis of the output signals generated by the $N$-port receiver in response to the feeding of the calibration signals.

In their article "Design Considerations for Direct-Conversion Receivers using Five-Port Circuit" (EUWC 2001), the authors M. Ratni, D. Krupezevic, V. Brankovic, M. Abe, N. Sasho introduce the basic five-port structure, including its basic concept, the benefits of low-power consumption and broadband transmission, implementation issues, an improved power detector and special requirements for an accurate coefficient calibration.

An I/Q impairment correction is described in the three articles "A Novel Adaptive Mismatch Cancellation System for Quadrature IF Radio Receivers" by L. Yu and W.M. Snelgrove, "Maximum Likelihood Technique to Quadrature Parameter Estimation" (Proc. of the International Conference on Acoustics, Speech, and Signal Processing (ICASSP'94), vol. IV, pp. 561 to 564, Adelaide, Australia, April 1994) by J.W. Pierre and R.A. Green, and "Considerations in the Autocalibration of Quadrature Receivers" (Proc. of the International Conference on Acoustics, Speech, and Signal Processing (ICASSP'95), Detroit, May 1995) by J.W. Pierre and D.R. Fuhrmann.

EP 0 884 836 A illustrates a conventional calibration method wherein calibration is conducted in analog/RF domain and the calibrated signals are sent to the I/Q demodulator for baseband processing.

Thereby, in "Maximum Likelihood Technique to Quadrature Parameter Estimation" (Proc. of the International Conference on Acoustics, Speech, and Signal Processing (ICASSP'94), vol. IV, pp. 561 to 564, Adelaide, Australia, April 1994) by J.W. Pierre and R.A. Green a Maximum Likelihood (ML) approach is presented for the gain imbalance estimation in a quadrature receiver which can be used for array processing applications. Besides, formula derivations are provided as well as different simulations needed for testing its performance. The article "Considerations in the Autocalibration of Quadrature Receivers" (Proc. of the International Conference on Acoustics, Speech, and Signal Processing (ICASSP'95), Detroit, May 1995) by J.W. Pierre and D.R. Fuhrmann provides the basic mathematical mode and a simple algorithm for a DC offset cancellation and I/Q mismatch correction. Its performance is confirmed by simulation. For the I/Q mismatch introduced by gain and/or phase imbalances of the applied quadrature mixers, the article "A Novel Adaptive Mismatch Cancellation System for Quadrature IF Radio Receivers" by L. Yu and W.M. Snelgrove illustrates a complex Least Mean Square (LMS) algorithm and an adaptive noise cancellation to separate the desired signal and the image noise caused by the I/Q mismatch. However, all these papers only consider an I/Q impairment correction for a conventional RF receiver structure.

DEFICIENCIES AND DISADVANTAGES OF THE PRIOR ART SOLUTIONS

A problem that arises when conventional power detectors, which can simply be realized as commercially available detector diodes, are deployed as basic elements for the down-conversion of modulated RF band-pass signals in a mobile RF receiver is their non-linear behavior caused by imperfections of their analog electronic components. For that reason it is difficult when applying the known calibration procedure to obtain accurate calibration coefficients to be used to calculate the inphase (I) and quadrature (Q) phase of the complex-valued baseband signal from three input power levels, which will introduce I/Q imbalances and DC offsets.

OBJECT OF THE UNDERLYING INVENTION

In view of the explanations mentioned above, it is the object of the underlying invention to propose a new calibration procedure for the quadrature modulator of a mobile RF receiver with a five-port circuit topology which can be used for measuring, processing and direct down-converting modulated RF band-pass signals from the passband to the baseband, thereby eliminating the I/Q imbalances and DC offsets introduced by the imperfections of the applied hardware, such as e.g. imbalances of the power detectors (e.g. transistors) and inaccurate known calibration procedures.

This object is achieved by means of the features in the independent claims 1 and 4. Advantageous features are defined in the subordinate claims.

SUMMARY OF THE INVENTION

The proposed approach according to the underlying invention is basically dedicated to an adaptive autocalibration procedure for the quadrature demodulator of a mobile RF receiver with a five-port circuit topology, which supports the processing and direct down-conversion of modulated broadband RF band-pass signals. In this connection, the underlying invention combines the conventional idea of an I/Q impairment correction with an adaptive five-port parameter calibration providing optimized calibration coefficients. The evaluation of the calibration coefficients, which are used to calculate the inphase (I) and the quadrature (Q) component of the complex-valued baseband signal from three input power levels supplied by the five-port junction device, is carried out by a digital front-end (DFE). Thereby, hardware complexity and power consumption can significantly be reduced.

BRIEF DESCRIPTION OF THE DRAWINGS

Further advantages of the underlying invention result from the subordinate claims as well as from the following description of one embodiment of the underlying invention, which is depicted in the following drawings. Herein,

Fig. 1    presents a block diagram showing an overview of a five-port circuit topology attached to the quadrature demodulator of a mobile RF receiver comprising a five-port junction device with three power detectors and a digital signal processor according to the state of the art,

Fig. 2a    exhibits a block diagram of a non-reciprocal active circuitry for a five-port junction device according to the state of the art providing a passive isolation between the received RF band-pass signal and a carrier signal originating from a local oscillator,

Fig. 2b    shows a detailed view of the components contained in the passive four-port network according to the state of the art,

Fig. 3    presents a signal flow diagram for a conventional digital front-end (DFE) according to the state of the art, which is attached to the DC interface of the mobile RF receiver and applied to execute the proposed calibration approach by calculating the inphase (I) and quadrature (Q) component of the complex-valued baseband signal from three input power levels,

Fig. 4    outlines a mathematical model illustrating the emergence of the I/Q mismatch,

Fig. 5    shows a signal flow diagram which illustrates the principle of the applied DC offset cancellation and I/Q imbalance correction according to one embodiment of the underlying invention, and

Fig. 6    shows a signal flow diagram for a new digital front-end (DFE) according to one embodiment of the underlying invention, which is attached to the DC interface and applied to execute the proposed calibration approach by calculating the inphase (I) and quadrature (Q) component of the complex-valued baseband signal from three input power levels.

DETAILED DESCRIPTION OF THE UNDERLYING INVENTION

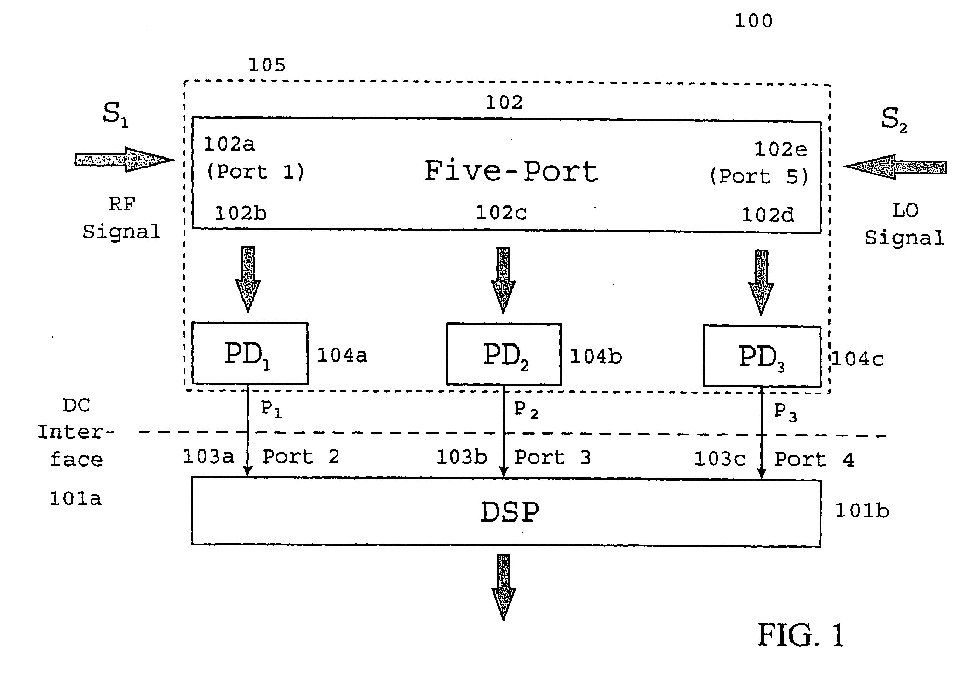

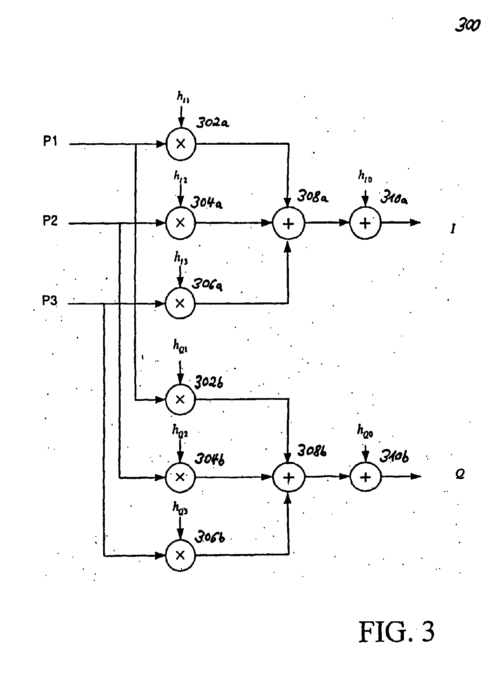

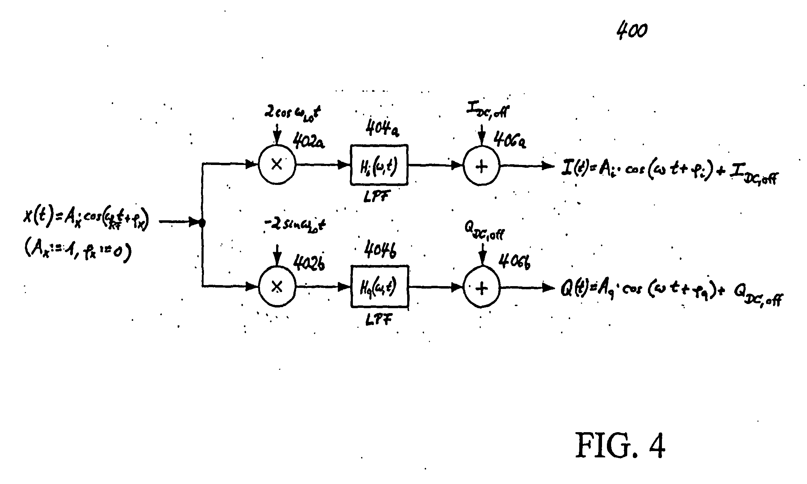

In the following sections, the functions of the structures contained in one embodiment of the underlying invention as depicted in Figs. 1, 2a+b, 5 and 6 are explained in comparison with an already known solution according to the state of the art as depicted in Figs. 3 and 4. The meaning of the symbols designated with reference signs in Figs. 1 to 6 can be taken from the annexed table.

In Fig. 1, a block diagram 100 is depicted which gives an overview of the applied five-port network. The herein disclosed five-port structure 105 comprises a five-port junction device 102 connected with three power detectors 104a-c according to the state of the art. In this structure, the five-port junction device 102 acts as an isolation between a first RF signal ($S_1$) representing the received band-pass signal and a second RF signal ($S_2$) originating from a local oscillator (LO) which is used for the direct down-conversion of $S_1$ from the passband to the baseband.

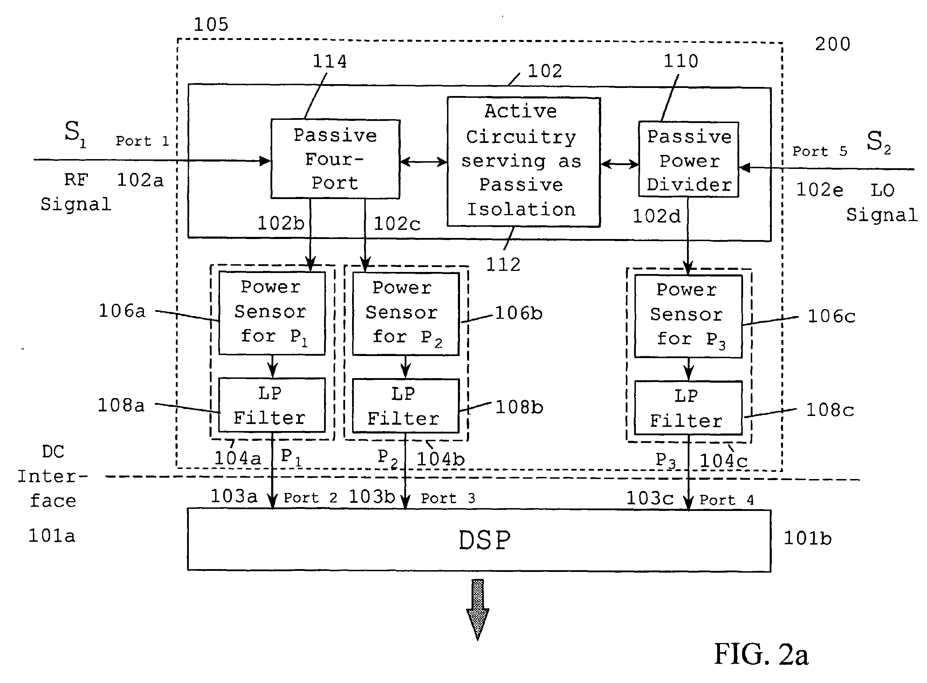

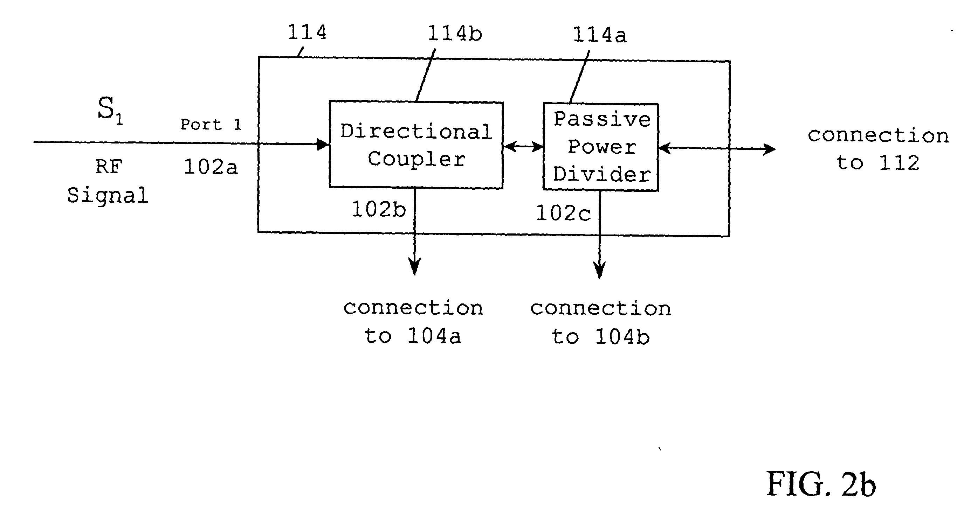

The topology of the applied five-port junction device 102 is shown in Figs. 2a and 2b. It includes three passive three-port structures comprising one directional coupler 114b and two power dividers 110 and 114a, one phase shifter 112, which is realized as an active circuitry, and three power detectors 104a-c, which are used instead of conventional mixers. For this reason, low power consumption and broadband transmission can be guaranteed. The output signals of the power detectors are transferred to three amplifiers (not shown in Fig. 2a) which respectively provide the power levels $P_1$, $P_2$, and $P_3$ at their output ports 103a-c. The two complex-valued input signals of the five-port junction device 102 are the RF signal $S_1$ and the carrier signal $S_2$ originating from the local oscillator (LO).

The basic concept of the proposed five-port topology can be taken from Fig. 2a, wherein a solution according to the state of the art is shown. It comprises one passive four-port network 114 and one passive power divider realized as a passive three-port network 110 connected with each other by a non-reciprocal active circuitry 112, which acts as a passive isolation between the RF signal ($S_1$) and the LO signal ($S_2$). Thereby, $S_1$ and $S_2$ are the input signals of the passive power divider 110 and the passive four-port network 114, respectively.

The passive power divider 110 comprises one port 102e for the input of the LO signal ($S_2$), one port for the connection with the non-reciprocal active circuitry 112 and one port 102d for the output of a signal representing the power level $P_3$ which is sent to the power sensor 106c. By contrast, the passive four-port network 114 comprises one port 102a for the input of the RF signal ($S_1$), one port for the connection with the non-reciprocal active circuitry 112 and two ports 102b and 102c for the output of two signals representing the power levels $P_1$ and $P_2$ which are sent to the power sensors 106a and 106b, respectively. When the disclosed topology is used as an RF receiver, the power sensors 106a-c can be matched, e.g. on an impedance of 50 Ω.

The output signals of the passive four-port network 114 and the passive power divider 110 represent linear combinations and eventually phase shifts of the two input RF signals ($S_1$ and $S_2$) . The power sensors 106a-c detect the power levels ($P_1$, $P_2$, and $P_3$) of the output signals at the output ports 103a, 103b and 103c of the passive five-port network 102, which are then supplied to a digital signal processor unit 101b. Usually, a plurality of circuit elements such as low-pass filters, DC amplifiers and analog-to-digital converters (not shown in the drawings) are inserted between each of said power sensors 106a-c and the digital signal processor 101b.

Fig. 2b shows a detailed view of the components contained in the passive four-port network 114 according to the state of the art. These components comprise a passive power divider 114a and a directional coupler 114b realized as a passive three-port network, which are connected to each other and with the output ports 102b+c of said passive four-port network 114.

In the following, a brief mathematical description of the method according to the preferred embodiment of the underlying invention yielding the inphase (I) and quadrature (Q) component of the complex-valued baseband signal shall be given.

In a conventional five-port receiver as depicted in Figs. 1, 2a, and 2b, a digital signal processor 101b, which serves as a quadrature demodulator, calculates the complex-valued ratio

$$S := \frac{S_1}{S_2} = \frac{|S_1| \cdot e^{j \cdot arc(s_1)}}{|S_2| \cdot e^{j \cdot arc(s_2)}} = d \cdot e^{j \cdot arc(s)}$$

$$= d \cdot cos\left[arc(s)\right] + j \cdot d \cdot sin\left[arc(s)\right] = I + j \cdot Q \in C \quad (1)$$

of the received RF band-pass signal ($S_1$) and the carrier signal ($S_2$) originating from the local oscillator (LO) by means of the detected power levels ($P_1$, $P_2$, and $P_3$) at the output ports 103a-c of the disclosed five-port network 105 in order to provide a quadrature demodulation of the received RF band-pass signal ($S_1$). In this connection, the signals $S_1$ and $S_2$ are represented by their amplitudes $|S_i|$ and phases $arc$ ($S_i$) (with $i$ = 1 and $i$ = 2, respectively):

$$S_1 := |S_1| \cdot e^{j \cdot arc(s_1)} \in C \ \sqrt{W}, \ |S_1| = \sqrt{P_{RF}}, \ \text{and} \quad (2)$$

and

$$S_2^i := |S_2| \cdot e^{j \cdot arc(s_2)} \in C \ \sqrt{W}, \ |S_2| = \sqrt{P_{LO}}, \quad (3)$$

wherein

$P_{RF}$ denotes the power level of the received RF band-pass signal,

$P_{LO}$ denotes the power level of the carrier signal originating from the LO,

$d := |S| = |S_1|/|S_2|$ is the amplitude ratio of the two complex-valued signals $S_1$ and $S_2$,

$arc(s) := arc(S_1)-arc(S_2)$ [deg] is the phase of the ratio $S$,

$I := Re\{S\} = d \cdot cos[arc(s)]$ denotes the inphase signal of the ratio $S$,

$Q := Im\{S\} = d \cdot sin[arc(S)]$ denotes the quadrature signal of the ratio $S$, and

$j :=$

$$\sqrt{-1}$$

is the imaginary unit.

In this connection, $S$ is the actually wanted RF signal which has to be demodulated by means of a mathematical procedure, thereby using the input power levels $P_1$, $P_2$, and $P_3$ detected by the power detectors 104a-c and the already known power level $P_{LO}$ of the LO signal $S_2$, which is assumed to be constant. These power levels are treated in such a way that the inphase (I) and the quadrature (Q) component can be calculated by means of the following equations:

$$I = h_{I0} + \sum_{k=1}^{3} h_{Ik} \cdot P_k \ , \ \ \text{and} \qquad (4)$$

and

$$Q = h_{Q0} + \sum_{k=1}^{3} h_{Qk} \cdot P_k \ . \qquad (5)$$

For an approximation of the I/Q values, these linear combinations of the power detector readings $P_1$, $P_2$, and $P_3$ are calculated with the aid of an analog and/or digital hardware realization. In conventional solutions this is usually done with the aid of a digital front-end 300 (DFE) as depicted in Fig. 3. In any case, the basic five-port concept relies on a weighted sum of the detected power levels $P_1$, $P_2$, and $P_3$ under various phase angles.

Thereby, the applied coefficients $h_{I0}$, $h_{I1}$, $h_{I2}$, $h_{I3}$, and $h_{Q0}$, $h_{Q1}$, $h_{Q2}$, $h_{Q3}$ in equations (4) and (5) correspond to the transfer function of the five-port junction device 102. Although their values are not known, they can roughly be determined by means of the calibration procedure, which takes into account the imperfections of the applied elements and therefore alleviates the tolerances of the deployed RF components. However, the accurate values for these coefficients do not only vary due to changes in carrier frequency and temperature, but also in case different boards using the same design are applied, which makes mass production of these five-port junction devices a difficult task. In addition, it is quite difficult to obtain the optimum values for these coefficients $h_{I0}$, $h_{I1}$, $h_{I2}$, $h_{I3}$, and $h_{Q0}$, $h_{Q1}$, $h_{Q2}$, $h_{Q3}$, which causes I/Q imbalances and DC offsets. Therefore it is difficult to use a conventional five-port junction device 102 for high-order Quadrature Amplitude Modulation (QAM) schemes, e.g. 64-QAM or 256-QAM.

According to the invention an approach is proposed which combines the idea of DC offset cancellation and I/Q imbalance correction with a conventional calibration procedure for a five-port junction device in order to realize an adaptive autocalibration.

Since the initial values for the coefficients $h_{I0}$, $h_{I1}$, $h_{I2}$, $h_{I3}$, and $h_{Q0}$, $h_{Q1}$, $h_{Q2}$, $h_{Q3}$ are not accurate, DC offsets and I/Q imbalances arise from the outputs of equations (4) and (5) illustrated in the equivalent mathematical model 400 depicted in Fig. 4. Thereby, $\omega_{RF}$ denotes the circular frequency of a continuous wave (CW) signal serving as an RF band-pass test signal $S_1$, here called $x(t)$, and $\omega_{LO}$ is the circular frequency of the carrier signal $S_2$ originating from a local oscillator (LO).

The linear time-invariant systems $H_i(\omega,t)$ and $H_q(\omega,t)$ in the inphase (I) and quadrature (Q) chain of the quadrature demodulator 101b depicted in Fig. 4, whose transfer functions are given at $\omega_0 := \omega_{RF} - \omega_{LO}$ by

$$H_i\big(\omega = \omega_0, t\big) = A_i\big(\omega = \omega_0, t\big) \cdot e^{j \cdot \varphi_i(\omega = \omega_0, t)} \ \ \text{and} \qquad (6)$$

and

$$H_q\big(\omega = \omega_0, t\big) = A_q\big(\omega = \omega_0, t\big) \cdot e^{j \cdot \varphi_q(\omega = \omega_0, t)} \qquad (7)$$

with

$$A_i\left(\omega = \omega_0, t\right) := \left|H_i\left(\omega = \omega_0, t\right)\right| ,$$

$$A_q\left(\omega = \omega_0, t\right) := \left|H_q\left(\omega = \omega_0, t\right)\right| ,$$

$$\varphi_i\left(\omega = \omega_0, t\right) := \angle\left(H_i\left(\omega = \omega_0, t\right)\right) ,$$

and

$$\varphi_q\left(\omega = \omega_0, t\right) := \angle\left(H_q\left(\omega = \omega_0, t\right)\right) .$$

primarily model low-pass filters which are needed to eliminate the frequency components at $\pm(\omega_{RF} + \omega_{LO})$ supplied by the down-conversion mixers 402a+b. However, these filters can also be used to model other gain and phase discrepancies in both the inphase (I) and the quadrature (Q) channel. From Fig. 4 it can be taken that the I/Q signals are impaired by DC offsets $I_{DC,off}$ and $Q_{DC,off}$. Furthermore, if the time-variant amplitude value $A_i(\omega = \omega_0, t)$ of the first transfer function $H_i(\omega = w_0, t)$ is not equal to the amplitude value $A_q(\omega = \omega_0, t)$ of the second transfer function $H_q(\omega = \omega_0, t)$, or if the time-variant phase value $\varphi_i(\omega = \omega_0, t)$ of the first transfer function $H_i(\omega = \omega_0, t)$ is not equal to the phase value $\varphi_q(\omega = \omega_0, t)$ of the second transfer function $H_q(\omega = \omega_0, t)$, a significant I/Q imbalance (mismatch) arises.

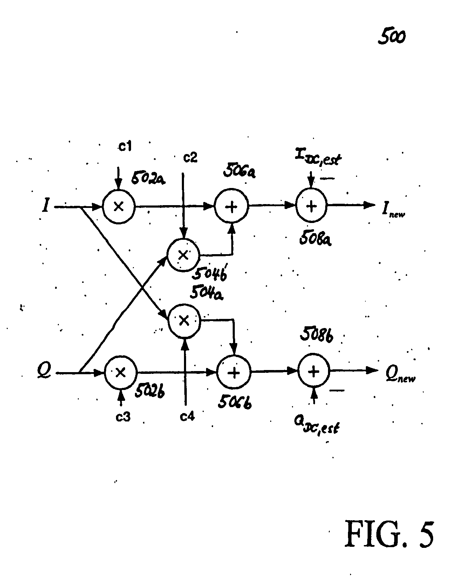

A signal flow diagram 500 showing the principle of the applied DC offset cancellation and I/Q imbalance correction according to one embodiment of the underlying invention is illustrated in Fig. 5. Thereby, the corrected I/Q signals can be calculated by means of the following equations:

$$I_{new} := c1 \cdot I + c2 \cdot Q - I_{DC,est} , \qquad (8)$$

$$Q_{new} := c4 \cdot I + c3 \cdot Q - Q_{DC,est} , \qquad (9)$$

wherein

$I$ is the inphase signal before calibration,

$Q$ is the quadrature signal before calibration,

$I_{new}$ is the inphase signal after calibration,

$Q_{new}$ is the quadrature signal after calibration,

$I_{DC,est}$ denotes a DC offset compensation for the I signal,

$Q_{DC,est}$ denotes a DC offset compensation for the Q signal,

$ck$ are the obtained calibration coefficients (for $k = 1,2,3,4$).

In case the values of the calibration coefficients $c1, c2, c3,$ and $c4$ can be estimated exactly as described in the articles "A Novel Adaptive Mismatch Cancellation System for Quadrature IF Radio Receivers" by L. Yu and W.M. Snelgrove, "Maximum Likelihood Technique to Quadrature Parameter Estimation" (Proc. of the International Conference on Acoustics, Speech, and Signal Processing (ICASSP'94), vol. IV, pp. 561 to 564, Adelaide, Australia, April 1994) by J.W. Pierre and R.A. Green, and "Considerations in the Autocalibration of Quadrature Receivers" (Proc. of the International Conference on Acoustics, Speech, and Signal Processing (ICASSP'95), Detroit, May 1995) by J.W. Pierre and D.R. Fuhrmann, there is no DC offset and no I/Q imbalance at all.

Using equations (4), (5), (8), and (9) yields the following formulas:

$$I_{new} = c1 \cdot \left( h_{I0} + \sum_{k=1}^{3} h_{Ik} \cdot P_k \right) + c2 \cdot \left( h_{Q0} + \sum_{k=1}^{3} h_{Qk} \cdot P_k \right) - I_{DC,est}$$

$$= h_{I0,new} + \sum_{k=1}^{3} h_{Ik,new} \cdot P_k \ , \quad (10)$$

$$Q_{new} = c4 \cdot \left( h_{I0} + \sum_{k=1}^{3} h_{Ik} \cdot P_k \right) + c3 \cdot \left( h_{Q0} + \sum_{k=1}^{3} h_{Qk} \cdot P_k \right) - Q_{DC,est}$$

$$= h_{Q0,new} + \sum_{k=1}^{3} h_{Qk,new} \cdot P_k \ , \quad (11)$$

with

$$h_{I0,new} := c1 \cdot h_{I0} + c2 \cdot h_{Q0} - I_{DC,est} \ , \quad (12)$$

$$h_{I1,new} := c1 \cdot h_{I1} + c2 \cdot h_{Q1} \ , \quad (13)$$

$$h_{I2,new} := c1 \cdot h_{I2} + c2 \cdot h_{Q2} \ , \quad (14)$$

$$h_{I3,new} := c1 \cdot h_{I3} + c2 \cdot h_{Q3} \ , \quad (15)$$

$$h_{Q0,new} := c4 \cdot h_{I0} + c3 \cdot h_{Q0} - Q_{DC,est} \ , \quad (16)$$

$$h_{Q1,new} := c4 \cdot h_{I1} + c3 \cdot h_{Q1} \ , \quad (17)$$

$$h_{Q2,new} := c4 \cdot h_{I2} + c3 \cdot h_{Q2} \ , \quad (18)$$

$$h_{Q3,new} := c4 \cdot h_{I3} + c3 \cdot h_{Q3} \ , \quad (19)$$

which are supplied by an off-line coefficient adjustment unit 602 . When these coefficients $h_{I0,new}$, $h_{I1,new}$, $h_{I2,new}$, $h_{I3,new}$ and $h_{Q0,new}$, $h_{Q1,new}$, $h_{Q2,new}$, $h_{Q3,new}$ are used instead of $h_{I0}$, $h_{I1}$, $h_{I2}$, $h_{I3}$, and $h_{Q0}$, $h_{Q1}$, $h_{Q2}$, $h_{Q3}$, both DC offset cancellation and I/Q imbalance correction are performed in the DFE module. In this connection, it should be noted that equations (12) to (19) are,evaluated off-line when the power consumption is relatively low.

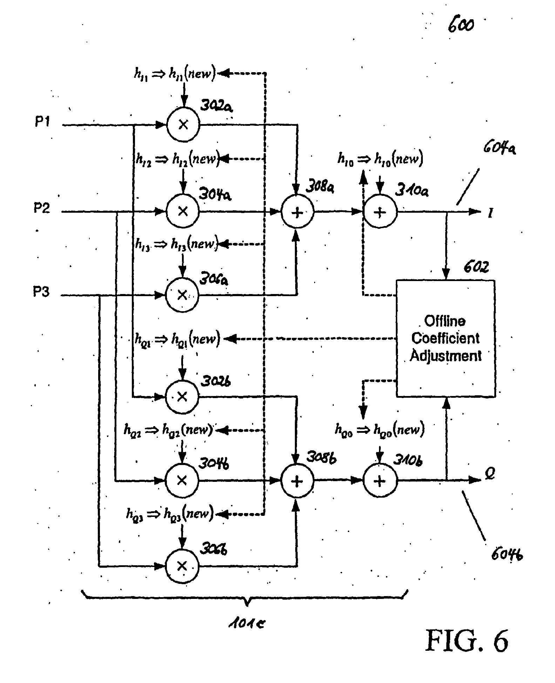

Finally, a flow diagram 600 for the signals related to the digital front-end (DFE) according to one embodiment of the underlying invention, which is attached to the DC interface 101a and applied to execute the proposed adaptive calibration approach by calculating the inphase (I) and quadrature (Q) component of the complex-valued baseband signal from three input power levels ($P_1$, $P_2$, and $P_3$), is shown in Fig. 6.

When applying this digital front-end 600 (DFE) optimized calibration coefficients can be obtained. For real-time operations, conventional DFE structures 300 require six multiplier elements 302a+b, 304a+b, and 306a+b and four summation elements 308a+b and 310a+b (cf. Fig. 3). In order to cope with I/Q impairments caused by inaccurate calibration coefficients, DC offset cancellation and I/Q imbalance correction are needed. In this case, four additional multiplier elements 502a+b and 504a+b and four additional summation elements 506a+b and 508a+b are used (cf. Fig. 5). By contrast, the proposed DFE module 600 as depicted in Fig. 6 only needs six multiplier elements 302a+b, 304a+b, and 306a+b and four summation elements 308a+b and 310a+b for on-line evaluation while simultaneously executing both I/Q calculation from three input power levels ($P_1$, $P_2$, and $P_3$), DC offset cancellation and I/Q imbalance correction.

According to one embodiment the calibration method for compensating DC offsets and/or I/Q mismatches of the inphase (I) and quadrature (Q) signal, which is performed in the production site off-line after chip manufacturing and/or chip assembly, comprises the steps of

- acquiring the power levels ($P_1$, $P_2$, and $P_3$) measured by the power detectors 104a-c at the output ports 102b-d of the five-port junction device 102 by the digital processing block 101c of the quadrature demodulator 101b,

- for all five-port devices produced, using the same initial calibration coefficients $h_{I0}$, $h_{Q0}$, $h_{I1}$, $h_{Q1}$ and $h_{I2}$, $h_{Q2}$, $h_{I3}$, $h_{Q3}$, to obtain I/Q values,

- for each individual five-port device, using an offline coefficient adjustment module 602 processing the I/Q values obtained with the initial calibration coefficients in order to obtain individual (new) optimized calibration coefficients $h_{I0\_NEW}$, $h_{Q0\_NEW}$, $h_{I1\_NEW}$, $h_{Q1\_NEW}$ and $h_{I2\_NEW}$, $h_{Q2\_NEW}$, $h_{I3\_NEW}$, $h_{Q3\_NEW}$ by performing a DC offset cancellation and/or I/Q imbalance correction,

- transferring said new calibration coefficients to the digital processing block 101c of the respective five-port device to replace the initial calibration coefficients.

Moreover, the underlying invention refers to an RF receiver of a mobile telecommunications device used for the processing and direct down-conversion of a modulated RF band-pass signal ($S_1$) from the passband to the baseband represented by the inphase (I) and quadrature (Q) component of the complex-valued equivalent low-pass signal forming its complex envelope. It comprises at least two RF input ports 102a+e supplied with the received modulated RF band-pass signal ($S_1$) and a carrier signal ($S_2$) originating from a local oscillator, respectively, which are fed to the input ports 102a+e of a five-port junction device 102 serving as a passive isolation between said input signals ($S_1$ and $S_2$). Furthermore, it comprises at least three power detectors used for detecting the power levels ($P_1$, $P_2$, and $P_3$) of the obtained signals at the output ports of said five-port junction device 102, one off-line coefficient adjustment unit 602 obtain a set of new real-valued weighting factors $h_{I0\_NEW}$, $h_{Q0\_NEW}$, $h_{I1\_NEW}$, $h_{Q1\_NEW}$, $h_{I2\_NEW}$, $h_{Q2\_NEW}$, $h_{I3\_NEW}$, $h_{Q3\_NEW}$ serving as calibration coefficients for the detected power levels ($P_1$, $P_2$, and $P_3$) and to adapt the inphase (I) and quadrature (Q) signal by performing a DC offset cancellation and/or I/Q imbalance correction, at least one digital processing block 101c comprising multiplier elements 302a+b, 304a+b, and 306a+b and summation elements 308a+b and 310a+b used for the processing of said power levels and calibration coefficients, and two output ports 604a+b for the obtained inphase (I) and quadrature (Q) signal. Thereby, a digital front-end 600, which is attached to said five-port junction device 102, is applied executing a calibration method as described above.

Besides, the underlying invention also pertains to a mobile telecommunications device comprising a mobile RF receiver as described above, wherein a digital front-end 600 serving as a quadrature demodulator 101b, which performs a calibration method as described above, and a five-port junction device 102 are applied.

The main advantages of the underlying invention consist in the realization of an adaptive parameter autocalibration for the quadrature demodulator 101b of a five-port receiver structure yielding the optimum calibration coefficients and the possibility to simultaneously reduce the hardware complexity of the applied baseband circuit 101b and its power consumption. Compared with conventional solutions according to the state of the art, the off-line calculation complexity is only slightly increased.

## Claims

1. A quadrature demodulator connected to a five-port junction device (102) of a mobile RF receiver, which five-port junction device is used for the direct down-conversion of a modulated RF signal ($S_1$) represented by an inphase (I) and a quadrature (Q) component, the quadrature demodulator (101b) comprising

- at least three input power detectors (104a-c) supplying detected power levels $(P_1, P_2, P_3)$ connected at a respective output port of said five-port junction device (102),
- at least one digital processing block (101c) comprising multiplier elements (302a+b, 304a+b, 306a+b) and summation elements (308a+b, 310a+b) used for the processing of said power levels $(P_1, P_2, P_3)$ and calibration coefficients corresponding to the transfer function of the five-port junction device ($h_{I0}$, $h_{Q0}$, $h_{I1}$, $h_{Q1}$, $h_{I2}$, $h_{Q2}$, $h_{I3}$, $h_{Q3}$), having two output ports (604a+b) supplying the baseband inphase (I) and quadrature (Q) signal, respectively,

**characterized by**

- a coefficient adjustment unit (602) optimizing a set of initial calibration coefficients ($h_{I0}$, $h_{Q0}$, $h_{I1}$, $h_{Q1}$, $h_{I2}$, $h_{Q2}$, $h_{I3}$, $h_{Q3}$) by replacing them with new calibration coefficients obtained by analysing said baseband inphase and quadrature signal obtained by performing a DC offset cancellation and/or I/Q imbalance correction on the basis of the initial calibration coefficients.

2. A demodulator according to claim 1,
   **characterized in that**
   said quadrature demodulator is designed to calculate a linear combination of the three input power levels ($P_1$, $P_2$, $P_3$) measured by the power detectors (104a-c) at the three output ports (102b-d) of the five-port junction device (102), thereby using the calibration coefficients ($h_{I0}$, $h_{Q0}$, $h_{I1}$, $h_{Q1}$, $h_{I2}$, $h_{Q2}$, $h_{I3}$, $h_{Q3}$) supplied by the off-line coefficient adjustment unit (602).

3. A demodulator according to claim 2,
   **characterized in that**
   the linear combination of the detected power levels $(P_1, P_2, P_3)$ measured by the power detectors (104a-c) is realized with the aid of the digital processing block (101c).

4. A calibration method for a quadrature demodulator of a five-port device to be used for which five-port junction device is used for the direct down-conversion of a modulated RF signal $(S_1)$ represented by an inphase (I) and a quadrature (Q) component,
   the calibration method comprising the steps of

   - acquiring power levels ($P_1$, $P_2$, and $P_3$) measured by power detectors (104a-c) at output ports (102b-d) of the five-port junction device (102)
   - processing said power levels and calibration coefficients corresponding to the transfer function of the five-port junction device in a digital processing block (101c) of the quadrature demodulator (101b) comprising multiplier elements and summation elements and supplying the baseband inphase and quadrature signal, I and Q,
   - using initial calibration coefficients ($h_{I0}$, $h_{Q0}$, $h_{I1}$, $h_{Q1}$, $h_{I2}$, $h_{Q2}$, $h_{I3}$, $h_{Q3}$) to obtain I/Q values,
   - using an offline coefficient adjustment module (602) to obtain optimized calibration coefficients ($h_{IG\_NEW}$, $h_{Q0\_NEW}$, $h_{I1\_NEW}$, $h_{Q1\_NEW}$ and $h_{I2\_NEW}$, $H_{Q2\_NEW}$, $h_{I3\_NEW}$, $h_{Q3\_NEW}$) by analysing said baseband inphase and quadrature signal in order to correct I/Q imbalances and/or DC offsets, and
   - replacing the initial calibration coefficients by the optimized calibration coefficients.

5. A calibration method according to claim 4,
   **characterized in that**
   the calibration procedure is performed off-line after chip manufacturing and/or chip assembly.

6. A mobile telecommunication device,
   **characterized by**
   An RF receiver device used for the processing and direct down-conversion of a modulated RF band-pass signal $(S_1)$ from the passband to the baseband represented by the inphase (I) and quadrature (Q) component of the complex-valued equivalent low-pass signal forming its complex envelope, the RF receiver comprising a quadrature demodulator according to claim 1.

**Patentansprüche**

1. Quadraturdemodulator, der mit einer Fünftor-Verzweigungsvorrichtung (102) eines mobilen HF-Empfängers verbunden ist, wobei die Fünftor-Verzweigungsvorrichtung für die direkte Abwärtswandlung eines modulierten HF-Signals ($S_1$), das durch eine Inphasen- (I) und eine Quadratur- (Q) Komponente dargestellt ist, verwendet ist, wobei der Quadraturdemodulator folgende Merkmale aufweist:

- mindestens drei Eingangsleistungsdetektoren (104a-c), die erfasste Leistungspegel ($P_1$, $P_2$, $P_3$) zuführen und an einem jeweiligen Ausgangstor der Fünftor-Verzweigungsvorrichtung (102) verbunden sind, und
- mindestens einen digitalen Verarbeitungsblock (101c), der Multipliziererelemente (302a+b, 304a+b, 306a+b) und Summierungselemente (308a+b, 310a+b) aufweist, die für das Verarbeiten der Leistungspegel ($P_1$, $P_2$, $P_3$) und von Kalibrierungskoeffizienten ($h_{I0}$, $h_{Q0}$, $h_{I1}$, $h_{Q1}$, $h_{I2}$, $h_{Q2}$, $h_{I3}$, $h_{Q3}$), die der Übertragungsfunktion der Fünftor-Verzweigungsvorrichtung entsprechen, verwendet sind, mit zwei Ausgangstoren (604a+b), die jeweils das Basisband-Inphasen- (I) und Quadratur- (Q) Signal liefern,

**gekennzeichnet durch**,

- eine Koeffizientenanpassungseinheit (602), die einen Satz von Anfangskalibrierungskoeffizienten ($h_{I0}$, $h_{Q0}$, $h_{I1}$, $h_{Q1}$, $h_{I2}$, $h_{Q2}$, $h_{I3}$, $h_{Q3}$) **durch** ein Ersetzen derselben durch neue Kalibrierungskoeffizienten, die **durch** ein Analysieren des Basisband-Inphasen- (I) und Quadratur-(Q) Signals erhalten werden, das **durch** ein Durchführen einer Gleichstromversatzaufhebung und/oder einer I/Q-Ungleichgewichtskorrektur auf der Basis der Anfangskalibrierungskoeffizienten erhalten wird, optimiert.

2. Demodulator nach Anspruch 1,
   **dadurch gekennzeichnet,**
   **dass** der Quadraturdemodulator entworfen ist, um eine Linearkombination der drei Eingangsleistungspegel ($P_1$, $P_2$, $P_3$), die durch die Leistungsdetektoren (104a-c) an den drei Ausgangstoren (102b-d) der Fünftor-Verzweigungsvorrichtung (102) gemessen werden, zu berechnen, wobei die Kalibrierungskoeffizienten ($h_{I0}$, $h_{Q0}$, $h_{I1}$, $h_{Q1}$, $h_{I2}$, $h_{Q2}$, $h_{I3}$, $h_{Q3}$), die durch die unabhängige Koeffizientenanpassungseinheit (602) geliefert werden, verwendet sind.

3. Demodulator nach Anspruch 2,
   **dadurch gekennzeichnet,**
   **dass** die Linearkombination der erfassten Leistungspegel ($P_1$, $P_2$, $P_3$), die durch die Leistungsdetektoren (104a-c) gemessen werden, unter Zuhilfenahme des digitalen Verarbeitungsblocks (101c) realisiert ist.

4. Kalibrierungsverfahren für einen Quadraturdemodulator einer Fünftor-Vorrichtung zu einer Verwendung für die Fünftor-Verzweigungsvorrichtung, die für die direkte Abwärtswandlung eines modulierten HF-Signals ($S_1$), das durch eine Inphasen- (I) und eine Quadratur- (Q) Komponente dargestellt ist, verwendet ist, wobei das Kalibrierungsverfahren die folgenden Schritte aufweist:

   - Ermitteln von Leistungspegeln ($P_1$, $P_2$, $P_3$), die durch Leistungsdetektoren (104a-c) an Ausgangstoren (102b-d) der Fünftor-Verzweigungsvorrichtung (102) gemessen werden,
   - Verarbeiten der Leistungspegel und von Kalibrierungskoeffizienten, die der Übertragungsfunktion der Fünftor-Verzweigungsvorrichtung entsprechen, in einem digitalen Verarbeitungsblock (101c) des Quadraturdemodulators (101b), der Multipliziererelemente und Summierungselemente aufweist und das Basisband-Inphasen- und Quadratursignal, I und Q, liefert,
   - Verwenden von Anfangskalibrierungskoeffizienten ($h_{I0}$, $h_{Q0}$, $h_{I1}$, $h_{Q1}$, $h_{I2}$, $h_{Q2}$, $h_{I3}$, $h_{Q3}$), um I/Q-Werte zu erhalten,
   - Verwenden eines unabhängigen Koeffizientenanpassungsmoduls (602), um durch ein Analysieren des Basisband-Inphasen- und Quadratursignals optimierte Kalibrierungskoeffizienten ($h_{I0\_NEU}$, $h_{Q0\_NEU}$, $h_{I1\_NEU}$, $h_{Q1-NEU}$, $h_{I2-NEU}$, $h_{Q2\_NEU}$, $h_{I3\_NEU}$, $h_{Q3\_NEU}$) zu erhalten, um I/Q-Ungleichgewichte und/oder Gleichstromversätze zu korrigieren, und
   - Ersetzen der Anfangskalibrierungskoeffizienten durch die optimierten Kalibrierungskoeffizienten.

5. Kalibrierungsverfahren nach Anspruch 4,
   **dadurch gekennzeichnet,**
   **dass** das Kalibrierungsverfahren unabhängig nach einem Chip-Herstellen und/oder einer Chip-Bestückung durchgeführt wird.

6. Mobile Telekommunikationsvorrichtung,
   **gekennzeichnet durch**

eine HF-Empfängervorrichtung, die zu dem Verarbeiten und der direkten Abwärtswandlung eines modulierten HF-Bandpass-Signals ($S_1$) von dem Durchlassband zu dem Basisband, das **durch** die Inphasen- (I) und Quadratur- (Q) Komponente des komplexwertigen äquivalenten Tiefpass-Signals, das seine komplexe Hüllkurve bildet, dargestellt ist, verwendet ist,

wobei der HF-Empfänger einen Quadraturdemodulator nach Anspruch 1 aufweist.

## Revendications

1.  Démodulateur en quadrature relié à un dispositif de jonction à cinq ports (102) d'un récepteur RF mobile, ledit dispositif de jonction à cinq ports étant utilisé pour la conversion à la baisse directe d'un signal RF modulé ($S_1$) représenté par une composante en phase (I) et une composante en quadrature (Q), le démodulateur en quadrature (101b) comprenant

    - au moins trois détecteurs de puissance d'entrée (104a-c) fournissant les niveaux de puissance détectés ($P_1$, $P_2$, $P_3$) reliés à un port de sortie respectif dudit dispositif de jonction à cinq ports (102),
    - au moins un bloc de traitement numérique (101c) comprenant des éléments de multiplication (302a+b, 304a+b, 306a+b) et des éléments de sommation (308a+b, 310a+b) utilisés pour le traitement desdite niveaux de puissance ($P_1$, $P_2$, $P_3$) et de coefficients de calibrage correspondant à la fonction de transfert du dispositif de jonction à cinq ports ($h_{I0}$, $h_{Q0}$, $h_{I1}$, boit $h_{I2}$, $h_{Q2}$, $h_{I3}$, $h_{Q3}$), ayant deux ports de sortie (604a+b) fournissant le signal en bande de base en phase (I) et en quadrature (Q), respectivement,
    **caractérisé par**.
    - une unité d'ajustement de coefficient (602) optimisant un ensemble de coefficients de calibrage initiaux ($h_{I0}$, $h_{Q0}$, $h_{I1}$, $h_{Q1}$, $h_{I2}$, $h_{Q2}$, $h_{I3}$, $h_{Q3}$) en les remplaçant par de nouveaux coefficients de calibrage obtenus en analysant lesdits signaux en bande de base en phase et en quadrature obtenus en effectuant une annulation de décalage CC et/ou une correction de déséquilibre I/Q sur la base des coefficients de calibrage initiaux.

2.  Démodulateur selon la revendication 1, **caractérisé en ce que**
    ledit démodulateur en quadrature est conçu afin de calculer une combinaison linéaire des trois niveaux de puissance d'entrée ($P_1$, $P_2$, $P_3$) mesurés par les détecteurs de puissance (104a-c) au niveau des trois ports de sortie (102bd) du dispositif de jonction à cinq ports (102), en utilisant ainsi les coefficients de calibrage ($h_{I0}$, $h_{Q0}$, $h_{I1}$, $h_{Q1}$ $h_{I2}$, $h_{Q2}$, $h_{I3}$, $h_{Q3}$) fournis par l'unité d'ajustement de coefficient hors-ligne (602).

3.  Démodulateur selon la revendication 2, **caractérisé en ce que**
    la combinaison linéaire des niveaux de puissance détectés ($P_1$, $P_2$, $P_3$) mesurés par les détecteurs de puissance (104a-c) est réalisée à l'aide du bloc de traitement numérique (101c).

4.  Procédé de calibrage destiné à un démodulateur en quadrature d'un dispositif à cinq ports devant être utilisé, ledit dispositif de jonction à cinq ports étant utilisé pour la conversion à la baisse directe d'un signal RF modulé ($S_1$) représenté par une composante en phase (I) et une composante en quadrature (Q),
    le procédé de calibrage comprenant les étapes consistant à

    - acquérir les niveaux de puissance ($P_1$, $P_2$, $P_3$) mesurés par des détecteurs de puissance (104a-c) au niveau des ports de sortie (102b-d) du dispositif de jonction à cinq ports (102),
    - traiter lesdits niveaux de puissance et les coefficients de calibrage correspondant à la fonction de transfert du dispositif de jonction à cinq ports dans un bloc de traitement numérique (101c) du démodulateur en quadrature (101b), comprenant des éléments de multiplication et des éléments de sommation et fournissant les signaux en base de bande en phase et en quadrature, I et Q,
    - utiliser les coefficients de calibrage initiaux ($h_{I0}$, $h_{Q0}$, $h_{I1}$, $h_{Q1}$, $h_{I2}$, $h_{Q2}$, $h_{I3}$, $h_{Q3}$) afin d'obtenir des valeurs I/Q,
    - utiliser un module d'ajustement de coefficients hors ligne (602) afin d'obtenir des coefficients de calibrage optimisés ($h_{I0\_NEW}$, $h_{Q0\_NEW}$, $h_{I1\_NEW}$, $h_{Q1\_NEW}$ et $h_{I2\_NEW}$, $h_{Q2\_NEW}$, $h_{I3\_NEW}$, $h_{Q3\_NEW}$) en analysant lesdits signaux en bande de base en phase et en quadrature afin de corriger les déséquilibres I/Q et/ou les décalages CC, et
    - remplacer les coefficients de calibrage initiaux par les coefficients de calibrage optimisés.

5.  Procédé de calibrage selon la revendication 4, **caractérisé en ce que**
    la procédure de calibrage est effectuée hors ligne après la fabrication de la puce et/ou l'assemblage de la puce.

**6.** Dispositif de télécommunications mobiles, **caractérisé par**
un récepteur RF utilisé pour le traitement et la conversion à la baisse directe d'un signal passe-bande RF modulé ($S_1$), de la bande passante à la bande de base, représenté par la composante en phase (I) et la composante en quadrature (Q) du signal passe-bas équivalent à valeur complexe formant son enveloppe complexe, le récepteur RF comprenant un démodulateur en quadrature selon la revendication 1.

FIG. 1

EP 1 398 872 B1

FIG. 2a

FIG. 2b

EP 1 398 872 B1

300

$h_{I1}$

302a

P1

$h_{I2}$

304a

308a

$h_{I0}$

310a

P2

$h_{I3}$

306a

I

$h_{Q1}$

302b

$h_{Q2}$

304b

308b

$h_{Q0}$

310b

P3

$h_{Q3}$

306b

Q

FIG. 3

EP 1 398 872 B1

FIG. 4

FIG. 5

EP 1 398 872 B1

FIG. 6

EP 1 398 872 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 9808329 W
- EP 0957573 A1
- US 5498969 A

- EP 1067675 A1
- EP 0884836 A

**Non-patent literature cited in the description**

- **J. LI ; R. G. BOSSISIO ; K. WU.** A Six-Port Direct Digital Millimeter Wave Receiver. *Digest of the IEEE MTT Symposium,* May 1994, vol. 3, 1659-1662
- **L. YU ; W.M. SNELGROVE.** *A Novel Adaptive Mismatch Cancellation System for Quadrature IF Radio Receivers*

- **J.W. PIERRE ; R.A. GREEN.** Maximum Likelihood Technique to Quadrature Parameter Estimation. *Proc. of the International Conference on Acoustics, Speech, and Signal Processing (ICASSP'94,* April 1994, vol. IV, 561-564
- **J.W. PIERRE ; D.R. FUHRMANN.** Considerations in the Autocalibration of Quadrature Receivers. *Proc. of the International Conference on Acoustics, Speech, and Signal Processing (ICASSP'95,* May 1995